# FASCICULE DE BREVET EUROPEEN

(11) **EP 2 405 301 B1**
(45) Date de publication et mention de la délivrance du brevet: **29.04.2015**
(21) Numéro de dépôt: 10194393.4
(22) Date de dépôt: 09.12.2010
(51) Int. Cl.: G03F 7/00, G03F 7/09, B81C 1/00

(54) **Méthode de fabrication de pièces métalliques multi niveaux par un procédé du type LIGA et pièces obtenues par la méthode**
Herstellungsverfahren von mehrschichtigen Metallteilen mit Hilfe eines Verfahrens vom Typ LIGA, und mit dieser Methode hergestellte Teile
Manufacturing method for multi-level metal parts through a LIGA type process and parts obtained using the method

(30) Priorité: 09.07.2010 EP 10168988
(43) Date de publication de la demande: 11.01.2012
(73) Titulaire: Mimotec S.A., 1950 Sion (CH)
(72) Inventeur: Genolet, Grégoire, 1926, Fully (CH); Glassey, Marc-André, 1967, Bramois (CH)
(74) Mandataire: Leman Consulting S.A.

(56) Documents cités:
- EP-A1- 2 157 476
- EP-A1- 2 182 096

## Description

### Domaine de l'invention

La présente invention concerne le domaine de la fabrication de micro pièces métalliques par électroformage en particulier des pièces présentant au moins deux niveaux superposés auto-assemblés et imbriqués l'un dans l'autre, ayant chacun une forme prédéfinie. Certaines pièces utilisées dans l'horlogerie comme par exemple des ancres avec dard intégré, des engrenages avec dentures décalées etc., sont également des objets du domaine de l'invention ainsi que la méthode permettant de les réaliser avantageusement.

### Arrière plan technique

Le procédé de fabrication de micro pièces ou composants par irradiation d'une couche photosensible aux rayons ultraviolets suivie d'une étape d'électroformage est connu et est décrit par exemple dans le brevet EP0851295B1.

Ce procédé est dérivé de la technique LIGA (Lithographie Galvanoformung Abformung) qui consiste à:
- déposer sur un substrat une couche de 1 à 2000 µm d'une résine photosensible (photoresist);
- effectuer à travers un masque une irradiation au moyen d'un synchrotron ou par une exposition de rayons ultraviolets;
- développer, c'est-à-dire éliminer par des moyens chimiques les portions de photoresist non polymérisées et créer de ce fait une cavité ou un moule en photoresist.
- électroformer un métal dans cette cavité afin d'obtenir une micro pièce métallique.

L'avantage de cette technique est de réaliser des pièces ou composants mécaniques d'une très grande précision en X et Y et avec une épaisseur allant jusqu'à plusieurs millimètres. Il est également possible d'appliquer ce procédé en plusieurs étapes pour obtenir un composant en plusieurs niveaux, chaque niveau étant construit sur le précédent.

Ce procédé est décrit plus avant dans la demande de brevet EP1225477A1 et détaille le processus de masquage, d'irradiation et de dissolution de la partie non irradiée. Cette technique est bien connue pour la fabrication de pièces pour l'horlogerie tels que par exemple des roues dentées, des cames, bascules ou ponts.

Plusieurs techniques de fabrication de pièces multi niveaux basées sur le procédé LIGA sont décrites dans des documents de l'art antérieur à savoir :
WO2007/104171A2 qui décrit une méthode de fabrication d'une pièce à deux niveaux comprenant une étape de dépôt d'une couche d'or d'accrochage sur le premier niveau de la pièce précédant le dépôt du second niveau sur le premier. Il n'y a donc pas d'assemblage entre les niveaux, les couches adhèrent de façon planaire l'une par rapport à l'autre par le biais d'une couche d'accrochage.
WO2009/083488A1 qui décrit une technique de fabrication par le procédé LIGA d'une pièce en formant un moule de photoresist sur un substrat dans lequel est déposée galvaniquement une première couche uniforme d'un premier métal et ensuite une seconde couche d'un second métal enrobant la première couche. Il s'agit ici d'enrober une pièce à 1 niveau par un métal pour former une coque.
WO2010/020515A1 qui décrit la fabrication d'une pièce à plusieurs niveaux en réalisant un moule de photoresist complet correspondant à la pièce finale à obtenir avant l'étape de dépôt galvanique du métal de la pièce dans le moule. Seules des pièces multi-niveaux dont les projections des niveaux sont incluses l'une dans l'autre sont réalisables par cette méthode.

EP1462859A2 qui décrit un procédé multi niveaux de réalisation de pièces complexes dont les niveaux supérieurs sont un sous-ensemble des niveaux précédents. Deux niveaux différents sont formés en deux dépôts de photoresist pour former un moule. Avant la phase d'électroformage de la pièce, une couche conductrice est déposée sur les parois du moule pour que le dépôt des particules métalliques soit effectué de manière homogène. Comme dans le cas de la méthode décrite par le document précédent; seules des pièces multi-niveaux dont les projections des niveaux sont incluses l'une dans l'autre sont réalisables selon ce procédé.

EP2182096A1 qui décrit un procédé permettant la fabrication de pièces bimétals comprenant au moins un premier élément réalisé en un premier métal inséré dans un deuxième élément réalisé en un deuxième métal. Le premier métal électroformé est réalisé avec la même technologie que le reste de la pièce. Ainsi, un premier avantage de ce procédé réside dans le fait que le positionnement de l'élément électroformé relativement au deuxième élément peut être réalisé avec toute la précision micrométrique propre à la technique LIGA. Ce procédé permet de réaliser uniquement des pièces dont l'élément formant un premier niveau est enrobé dans le deuxième élément formant un second niveau. Ce procédé ne permet pas d'obtenir des pièces à deux niveaux superposés.

US5576147A qui décrit un procédé de fabrication de pièces métalliques à plusieurs niveaux superposés par superposition de couches de photoresist préformées comportant des orifices aux formes variées et usinées à des épaisseurs prédéfinies. Le métal est déposé successivement dans les orifices de chaque couche de photoresist pour former une pièce mono métal à plusieurs niveaux superposés et non imbriqués l'un dans l'autre.

EP2157476A1 qui décrit un procédé de fabrication de pièces métalliques multi-niveaux par la technologie LIGA-UV. Chaque couche de photoresist formant les niveaux de la pièce est creusée d'ouvertures formant un moule dans lequel est déposé par électroformage une couche métallique. Les pièces obtenues sont composées de niveaux formés dans un seul métal ou dans plusieurs métaux différents. Ces niveaux sont superposés et non imbriqués les uns dans les autres. De plus, le procédé ne permet de réaliser que des pièces dont les niveaux superposés sont inclus les uns dans les autres

EP2060534A1 qui décrit un procédé de fabrication d'une pièce de micromécanique composite silicium - métal. Selon une première variante une couche métallique est déposée par électroformage dans une cavité d'une couche en silicium posée sur un substrat. Le métal croît à partir du substrat au fond de la cavité et la remplit entièrement. Selon un seconde variante, une couche de photoresist est déposée sur le substrat et sur la couche en silicium pour former un moule d'un second niveau de la pièce au-dessus de la cavité. Une couche d'accrochage peut également être déposée sur la surface du premier niveau avant la déposition de la couche métallique du second niveau. La pièce obtenue comporte deux niveaux superposés non imbriqués et inclus l'un dans l'autre et pouvant comportant une couche intermédiaire d'accrochage.

### Description sommaire de l'invention

Le but de la présente invention est de fabriquer des micro-pièces mécaniques métalliques tridimensionnelles à plusieurs niveaux auto-assemblées par imbrication réalisées en plusieurs phases d'électroformage. Les différents niveaux de ces micro-pièces peuvent être composés de matériaux différents.

Ce but est atteint par une méthode de fabrication de pièces métalliques comportant au moins deux niveaux obtenus par photolithographie et électroformage, cette méthode comprend des étapes définies selon la revendication 1.

La pièce réalisée par la méthode comporte deux niveaux imbriqués l'un dans l'autre grâce à la croissance du deuxième niveau dans l'espace formé dans la première couche métallique de façon adjacente à un flanc de celle-ci. Il s'agit d'un auto-assemblage.

Le moule du premier niveau pouvant comporter un ou plusieurs étages peut être obtenu soit par le procédé LIGA, soit par une combinaison de gravure profonde du substrat et du procédé LIGA.

Dans le cas d'un premier moule à deux étages ou plus, le contour de la cavité du moule formée par un étage supérieur s'étend soit entièrement au-delà du contour de la cavité d'un étage inférieur, soit en partie avec des portions de contour de l'étage supérieur coïncidant avec le contour de l'étage inférieur.

Selon une première variante, le flanc et l'espace adjacent forment un orifice traversant, de forme quelconque, dans la première couche métallique dont le fond est constitué par le substrat. Le pourtour de l'orifice est ainsi entièrement formé par le métal de la première couche. Le métal de la seconde couche du second niveau remplit l'orifice à partir du substrat en se liant avec le métal des flancs de l'orifice pour s'étaler sur la base du second moule en atteignant une épaisseur prédéfinie. Selon une seconde variante, le pourtour de cet espace est formé par une portion du flanc de la première couche métallique et une portion du flanc de la seconde couche de photoresist. La forme de l'espace est ainsi définie par celle des portions de flanc de la couche métallique et de flanc de la couche de photoresist. Le métal de la seconde couche remplit l'espace en enrobant la portion de flanc de la première couche métallique. Cette portion de flanc comporte de préférence des creux et/ou des protubérances assurant un enrobage solide excluant une séparation ultérieure des niveaux par des forces de cisaillement.

Il est à noter que le nombre d'orifices et d'espaces adjacents à des portions de flancs de couche métallique n'est pas limité à un seul pour une même pièce. La première couche métallique peut en effet comporter plusieurs orifices et/ou plusieurs espaces entre le flanc de la couche et les parois de la cavité du moule.

Il est également à noter que la pièce ainsi obtenue peut être formée de différents matériaux tels que du NiP (nickel - phosphore) pour des parties devant être amagnétiques et/ou glissantes et du Ni (nickel) pour des parties nécessitant de bonnes propriétés mécaniques ressort. La pièce peut également être composée d'or et de nickel si des différences de densité sont nécessaires dans un même composant.

Selon une troisième variante, deux niveaux de résine peuvent former la cavité du moule pour le deuxième électroformage. Dans ce cas particulier, on peut ainsi définir un espacement entre le sommet du premier niveau et la base du deuxième niveau. Cet espacement étant défini par de la résine polymérisée sur le sommet du premier niveau.

Selon une quatrième variante, le moule du premier niveau peut être obtenu par une combinaison de gravure profonde du substrat et du procédé LIGA. Le contour du moule est défini par usinage du substrat selon des procédés de micro-fabrication classiques (photolithographie suivi d'une gravure profonde) et la cavité dans laquelle l'assemblage entre les niveaux va se faire est définie par un motif en photoresist.

La revendication 2 définit les étapes de la méthode utilisant un premier moule dont la cavité à un ou plusieurs étages est gravée dans le substrat.

Le photoresist permet de masquer la cavité qui va servir à la liaison entre les niveaux durant l'électroformage du premier niveau. Il sera éliminé avant la structuration du moule en photoresist du deuxième niveau de métal.

La présente invention concerne également une pièce micro mécanique composée d'au moins deux niveaux constitués chacun par une couche métallique obtenue par photolithographie, grâce à un moule de photoresist ou gravé dans le substrat, et par électroformage, caractérisée en ce que la couche métallique du second niveau est imbriquée et intimement liée à la couche métallique du premier niveau par au moins une portion de surface et de flanc de la couche métallique dudit premier niveau et en ce que le second niveau s'étend partiellement sur le premier niveau et sur une zone extérieure au voisinage dudit premier niveau de sorte que le contour d'une projection orthogonale du second niveau englobe une partie du contour du premier niveau.

Les niveaux de la pièce sont intimement liés entre eux grâce à la croissance de la seconde couche métallique dans la première. Cette croissance a lieu sur tout ou partie de la surface de la première couche métallique, dans un orifice et/ou sur une portion du contour de cette couche métallique. Une séparation des niveaux n'est ainsi pas possible sans détruire la pièce. Les niveaux sont ainsi auto-assemblés lors de l'électroformage du niveau supérieur et positionnés l'un par rapport à l'autre par procédé photolithographique.

### Brève description des figures

L'invention sera mieux comprise grâce à la description détaillée qui va suivre en se référant aux dessins annexés dans lesquels :
Les figures 1 à 4 montrent des exemples de pièces, vues en coupe et de dessus, fabriquées selon les procédés de l'art antérieur avec des niveaux superposés dont les projections sont incluses les unes dans les autres.
La figure 5 illustre les différentes étapes de la méthode selon l'invention pour obtenir une pièce à deux niveaux imbriqués l'un dans l'autre dont le premier niveau est défini par le procédé LIGA dans une cavité en photoresist.
la figure 6 illustre une variante de la méthode dans laquelle le moule de la partie supérieure de la pièce est défini par deux couches de photoresist. La pièce obtenue comporte un espacement entre les deux niveaux et définit ainsi une pièce à trois niveaux.
La figure 7 illustre une variante de la méthode dans laquelle la première couche métallique comporte un trou traversant qui sera rempli par le métal de la seconde couche formant le second niveau. L'assemblage entre les niveaux se faisant au niveau des flancs de cette cavité.
La figure 8 illustre une variante de la méthode dans laquelle la première couche métallique comporte un espace dont le pourtour est formé par une portion de flanc de la première couche métallique et une portion de paroi du moule de photoresist. Le métal de la seconde couche enrobe la portion du flanc de la première couche et permet ainsi l'assemblage entre les niveaux.
La figure 9 illustre les différentes étapes de la méthode selon l'invention pour obtenir une pièce à deux niveaux imbriqués l'un dans l'autre dont le premier niveau est défini par électroformage dans une cavité obtenue par une combinaison de gravure profonde du substrat et du procédé LIGA.
La figure 10 montre un exemple de pièce d'horlogerie réalisé par la méthode de l'invention en utilisant un premier moule gravé dans le substrat pour le premier niveau et deux moules de photoresist pour les deux niveaux supérieurs.
La figure 11 montre une variante dans laquelle le premier moule comporte deux étages réalisés par deux couches de photoresist, ce moule définissant le premier niveau de la pièce qui se compose ainsi de deux étages. La fabrication du deuxième niveau imbriqué dans l'espace 6 n'est pas illustrée.
La figure 12 montre une variante dans laquelle le premier moule comporte deux étages réalisés par gravure profonde du substrat, ce moule définissant le premier niveau de la pièce qui se compose ainsi de deux étages. La fabrication du deuxième niveau imbriqué n'est pas illustrée.
La figure 13 montre une variante mixte dans laquelle le premier moule comporte quatre étages dont deux réalisés par gravure profonde du substrat et deux réalisés par deux couches de photoresist, ce moule définissant le premier niveau de la pièce qui se compose ainsi de quatre étages. La fabrication du deuxième niveau imbriqué n'est pas illustrée.

### Description détaillée de l'invention

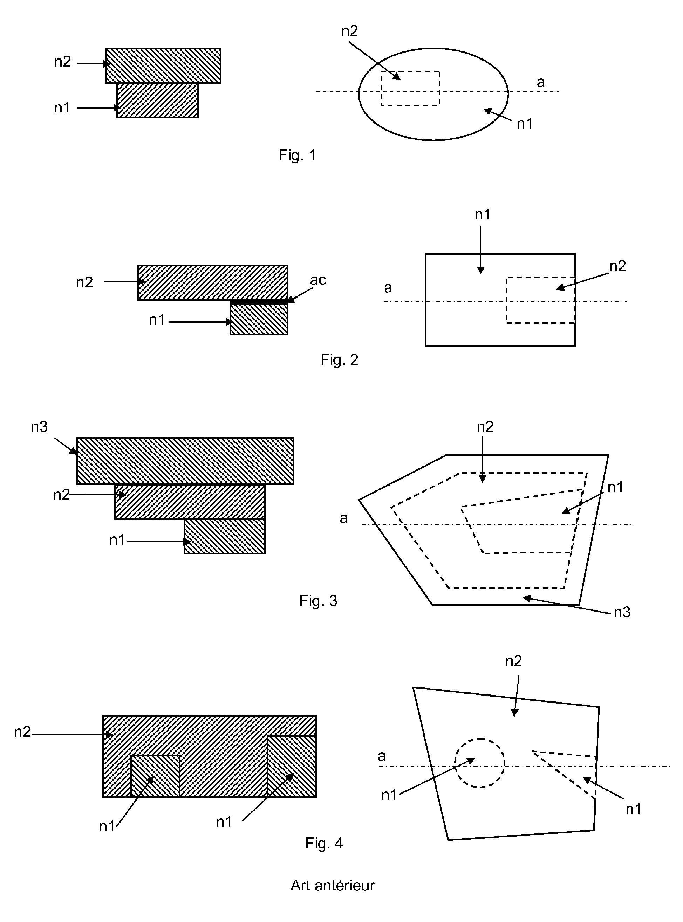

Les figures 1 à 4 représentent des coupes selon un axe a et les vues de dessus de pièces pouvant être obtenues par des méthodes basées sur le procédé LIGA décrites dans les documents de l'art antérieur mentionnés ci-dessus. La pièce de la figure 1 comporte deux niveaux n1 et n2 superposés et non imbriqués l'un dans l'autre. De plus, une projection orthogonale du premier niveau n1 est entièrement incluse dans celle du second niveau n2 comme le montre la vue de dessus de la pièce.

Il est à noter que lorsque la projection d'un niveau est incluse et tangente à la projection d'un autre niveau comme dans la figure 2, elle est considérée comme étant entièrement incluse dans l'autre niveau.

Afin d'améliorer l'adhésion du second niveau n2 au premier niveau n1, une couche intermédiaire d'accrochage ac peut être déposée avant l'électroformage du second niveau n2, voir figure 2. Dans ce cas, il n'y a aucun assemblage entre les niveaux.

La figure 3 montre un exemple de pièce à trois niveaux n2, n2 et n3 superposés non imbriqués et dont les projections orthogonales sont incluses les unes dans les autres.

La pièce de la figure 4 comporte un seul niveau dans lequel est imbriqué un élément d'un étage précédent d'une hauteur inférieure, dans un matériau différent et dont la projection est entièrement incluse dans le niveau final. L'élément imbriqué est réalisé selon le procédé LIGA lors d'une étape préalable. La méthode de fabrication de ce type de pièce est développée par exemple dans EP2157476A1.

Les pièces micro mécaniques de la présente invention comportent au moins deux niveaux imbriqués et non inclus l'un dans l'autre, c'est-à-dire que la projection orthogonale d'un niveau s'étend partiellement sur la projection orthogonale de l'autre niveau. La méthode et ses variantes décrites ci-dessous permettent de réaliser ce type de pièces avec la précision micrométrique du procédé LIGA.

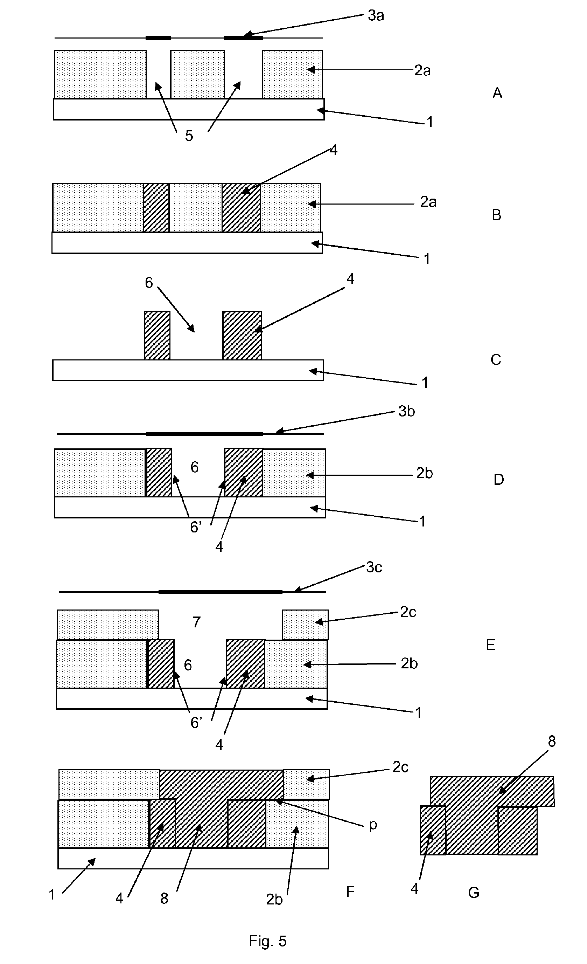

Dans les figures 5 à 8, le substrat 1 est généralement une plaque de verre, de silicium ou de métal sur laquelle est déposée une couche conductrice réalisée par exemple par une évaporation de chrome et d'or. Sur cette couche conductrice est déposée puis séchée une couche photorésist sensible aux rayons ultraviolets (ou aux rayons X selon la technologie choisie).

Cette couche de photoresist est ensuite irradiée par une source à ultraviolets ou à rayons X à travers une plaque en verre sur laquelle a été structuré un motif en chrome ou en or. Cette plaque avec sa découpe de chrome ou d'or est appelée un photomasque utilisé dans les étapes A, D et E de la méthode.

La lumière arrivant parfaitement perpendiculairement sur le photomasque, seules les portions de photorésist non protégées par le motif en chrome ou en or seront irradiées. Les flancs des portions de photoresist sont ainsi perpendiculaires au substrat.

Dans le cas particulier d'une résine négative comme par exemple le SU8 ou ses dérivés, un recuit de la couche de photorésist provoque la polymérisation dans les zones ayant reçu le rayonnement UV. Cette partie polymérisée devient insensible à la plupart des solvants par opposition aux zones non irradiées qui sont dissoutes par un solvant.

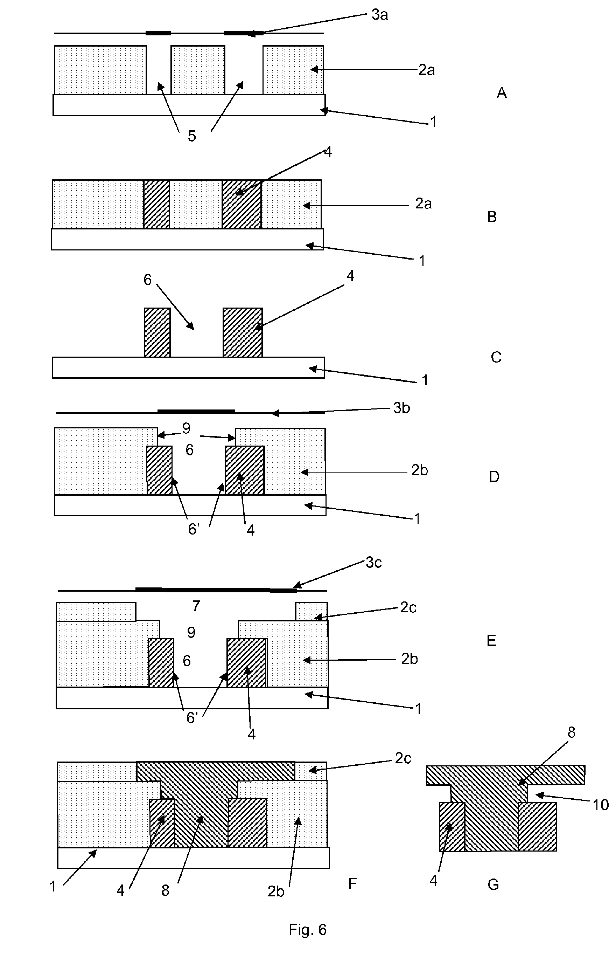

Les étapes A, B et C illustrées par les figures 5 et 6 sont des étapes de préliminaires de préparation d'une première couche métallique qui constituera le premier niveau de la pièce finale.

L'étape A consiste à déposer et irradier au travers d'un premier photomasque 3a, une première couche de photorésist 2a préalablement appliquée sur le substrat 1. Cette première couche 2a de photorésist est polymérisée selon le motif du photomasque 3a et les parties de la couche non polymérisée sont éliminées par voie chimique. La partie de photoresist restante forme un moule comportant une ou plusieurs cavités 5 dans lesquelles une première couche métallique 4 est déposée par électroformage, étape B.

La couche métallique 4 est ensuite usinée à une épaisseur prédéfinie et uniforme sur toute la surface de la couche. En effet, la surface brute d'une couche métallique électroformée est en général irrégulière et bombée par effet de « champignonnage » et de croissance inhomogène en épaisseur dû à la croissance du métal entre le substrat 1 et l'électrode ou les électrodes de l'outil de métallisation.

Le photoresist du moule est enlevé complètement pour ne laisser sur le substrat 1 que la première couche métallique 4 dont la forme et la structure est définie par le photomasque 3a qui a servi à la réalisation du moule, étape C. Les flancs du pourtour de la couche métallique sont perpendiculaires au substrat comme ceux du pourtour de la couche de photoresist. L'exemple de la figure 5 montre une coupe d'une couche métallique 4 en deux parties séparées par une espace 6 délimité par les flancs 6' de la couche métallique 4 et la couche métallique (non représentée) du substrat 1.

Une seconde couche de photoresist 2b est déposée sur le substrat et irradiée en utilisant un second photomasque 3b qui masque tout ou partie de la couche et au moins zone adjacente à une portion de flanc 6' de la couche métallique 4 formant l'espace 6. L'épaisseur de cette seconde couche de photoresist 2b est soit égale à celle de la première couche métallique 4 comme illustré par la figure 5, soit supérieure à la première couche métallique 4 comme illustré par la figure 6.

Cette seconde couche de photoresist 2b constituant la base du second niveau est polymérisée dans des zone définies par le photomasque 3b. Les autres zones non polymérisées sont éliminées de manière à laisser une partie de la couche servant à former la base ou le fond d'un moule destiné à créer le second niveau et au moins l'espace 6 traversant la première couche métallique 4 jusqu'au substrat 1. Cet espace 6 est défini par un pourtour constitué soit entièrement par le métal de la première couche métallique 4, soit par une portion du flanc 6' de ladite première couche métallique 4 et une portion de flanc 6" de la seconde couche de photorésist 2b, étape D.

A l'étape E, une troisième couche de photoresist 2c est déposée et irradiée à travers un troisième photomasque 3c dont le motif est configuré de manière à masquer une zone s'étendant partiellement ou entièrement sur la première couche métallique, une zone extérieure au voisinage de ladite couche métallique et l'espace 6 de la première couche métallique. Cette troisième couche de photoresist 2c est polymérisée et les parties non polymérisée de la couche sont éliminées. La partie polymérisée restante forme un espace 7 ou la cavité du moule définissant le second niveau. Cette cavité comprend également l'espace 6 dans la première couche métallique 4, cet espace 6 étant libre de photoresist.

A l'étape F une seconde couche métallique 8 et déposée par électroformage dans la cavité 7 du moule et dans l'espace 6. Le métal croît depuis le substrat 1 au fond de l'espace 6, sur les portions métalliques du pourtour de l'espace 6 et de la surface de la première couche métallique 4 à la base du second niveau de manière à occuper entièrement le moule. L'effet de « champignonnage » permet à la seconde couche métallique 8 de se propager aussi bien sur la surface non masquée de la première couche métallique 4 que sur une portion de surface de la couche de photoresist 2b formant une partie p du fond de la cavité 7 du second moule Cette couche de photoresist peut être recouverte d'une couche conductrice afin de faciliter le remplissage de la cavité 7 par le métal. Ce phénomène permet à la seconde couche métallique 8 de s'étendre partiellement au-delà de la surface de la première couche métallique 4 de sorte qu'une projection orthogonale du second niveau ne soit pas totalement incluse dans celle du premier niveau et vice-versa. De plus l'espace 6 permet à la seconde couche métallique 8 de s'imbriquer dans la première couche métallique 4 et assurer l'assemblage entre les deux niveaux par une liaison intime.

Cette seconde couche métallique 8 est usinée par un procédé mécanique d'une façon similaire à la première couche métallique 4 jusqu'à une épaisseur prédéterminée.

L'étape G consiste à enlever par des moyens chimiques les couches de photoresist 2b et 2c polymérisé du moule et le substrat afin de libérer une pièce métallique constituée de deux niveaux auto-assemblés.

Chaque niveau de cette pièce est défini par la première et la seconde couche métallique (4, 8) dont les contours et leur positionnement relatif sont définis par photolithographie, grâce à un moule de photoresist, et par électroformage. Le second niveau est imbriqué et intimement lié au premier niveau par une portion de flanc 6'. Selon la configuration du moule de photoresist lors de la réalisation du premier niveau, l'espace 6 est soit entièrement, soit partiellement entouré de métal. De plus, le second niveau s'étend à la fois partiellement ou entièrement sur le premier niveau et sur une zone extérieure au voisinage du premier niveau de sorte que le contour d'une projection orthogonale du second niveau par exemple englobe une partie du contour du premier niveau ou vice versa.

La figure 6 illustre une variante de la méthode dans laquelle, à l'étape D la seconde couche de photoresist (2b) est plus épaisse que la première couche métallique 4 et couvre partiellement celle-ci. Un espace supplémentaire 9 délimité par les flancs de la couche de photoresist en surépaisseur est ainsi formé au-dessus de l'espace 6 de la première couche métallique 4 par le motif du second photomasque 3b.

Le motif du troisième photomasque 3c de l'étape E est configuré de manière à former le second moule de photoresist de sorte que le second niveau s'étende au-delà de cet espace supplémentaire 9. La cavité du moule final de photoresist comporte ainsi trois étages constitués par la superposition de l'espace 6 de la première couche métallique 4, de l'espace 9 constitué par la surépaisseur de la seconde couche de photoresist 2b et de l'espace 7 délimité par les flancs de la troisième couche de photoresist 2c.

La pièce métallique obtenue à l'étape G comporte ainsi un niveau intermédiaire 10 entre le premier et le second niveau. Ces derniers sont imbriqués l'un dans l'autre par l'espace 6, le second niveau étant configuré de manière similaire à la variante précédente.

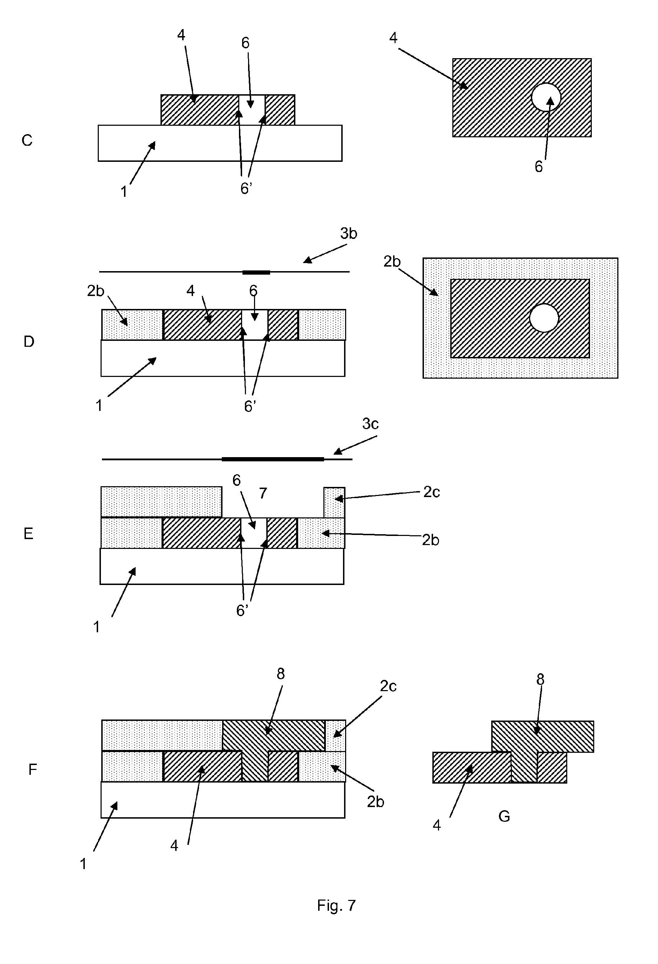

La figure 7 illustre une variante dans laquelle, l'espace 6 dans la première couche métallique 4 est entièrement entouré par le métal de cette couche en formant un orifice dont la forme est définie par le premier photomasque 3a à l'étape A. L'orifice 6 traverse entièrement la première couche métallique jusqu'au substrat 1.

Les étapes A et B ne sont pas représentée dans la figure 7 car elles sont similaires à celles des variantes des figures 5 et 6.

Dans cet exemple, la seconde couche de photoresist 2b entoure complètement la première couche métallique 4 sans laisser d'espace entre cette dernière et les flancs de la couche de photoresist 2b. Le second niveau est construit au-dessus du premier niveau au moyen du second moule dont le fond de la cavité 7 est constitué par au moins une partie de la première couche métallique 4 et une partie de la seconde couche de photoresist 2b polymérisée. L'orifice 6, dégagé de photoresist, est entièrement inclus à la cavité du moule servant à réaliser le second niveau.

La pièce obtenue à l'étape G après enlèvement du moule et du substrat 1 comporte deux niveaux imbriqués avec le métal du second niveau pénétrant à travers l'orifice du premier niveau.

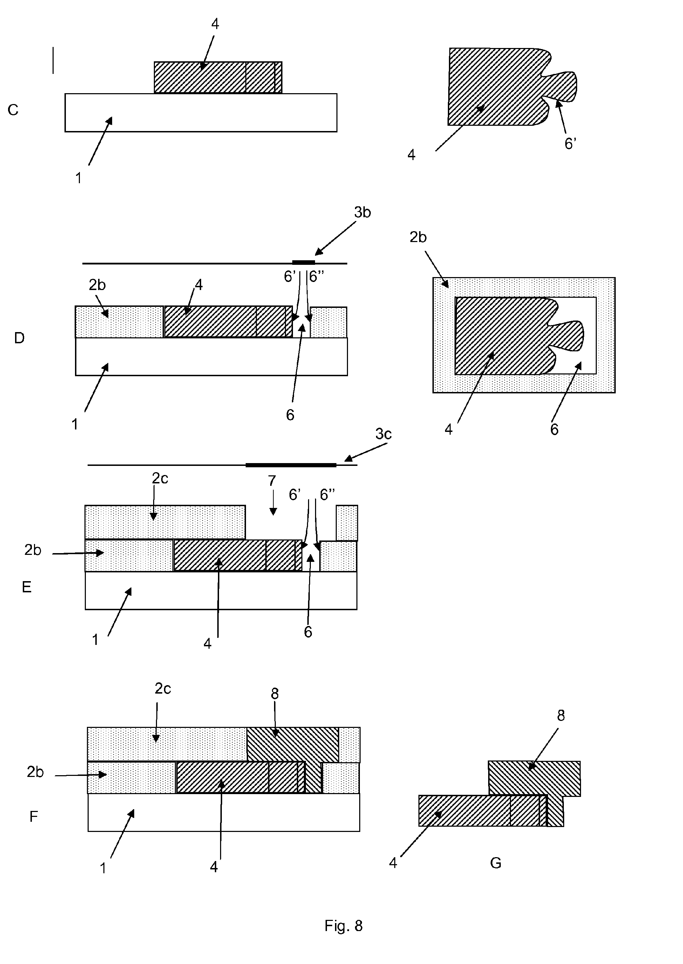

La variante de la figure 8 diffère de la variante de la figure 7 en ce que l'espace 6 n'est pas entièrement entouré du métal de la première couche métallique 4 mais également par une portion de flanc 6" de la seconde couche de photoresist 2b. Le contour de l'espace 6 est défini par le motif du second photomasque 3b configuré de manière à recouvrir une zone plus étendue que la zone occupée par la première couche métallique. Le troisième photomasque 3c utilisé pour former le moule du second niveau comporte un motif configuré de manière à laisser l'espace 6 libre de photoresist lors du dépôt la troisième couche 2c. La cavité du second moule est ainsi formée par la superposition des espaces 6 et 7 qui seront remplis par le métal du second niveau. Ce métal croît à la fois sur le substrat 1 au fond de l'espace 6 et sur la portion du flanc 6' de la première couche métallique 4 de manière à enrober cette portion de flanc. La forme de cette portion de flanc 6' comporte de préférence une suite de parties concaves et convexes de manière à assurer un effet d'imbrication du métal du second niveau dans celui du premier niveau, et vice versa, plus accentué et sur une plus grande longueur que dans le cas d'une portion de flanc rectiligne.

De manière plus générale, le flanc 6' de la première couche métallique 4 le long duquel la liaison entre les niveaux est effectuée est optimisé de manière à maximiser la surface de contact. En effet pour augmenter l'effet d'imbrication et de liaison intime entre les deux couches métalliques 4 et 8, le contour du flanc ou des portions flancs 6' de la première couche métallique 4 forme de préférence une ou plusieurs lignes brisées en segments de droites et/ou de courbes.

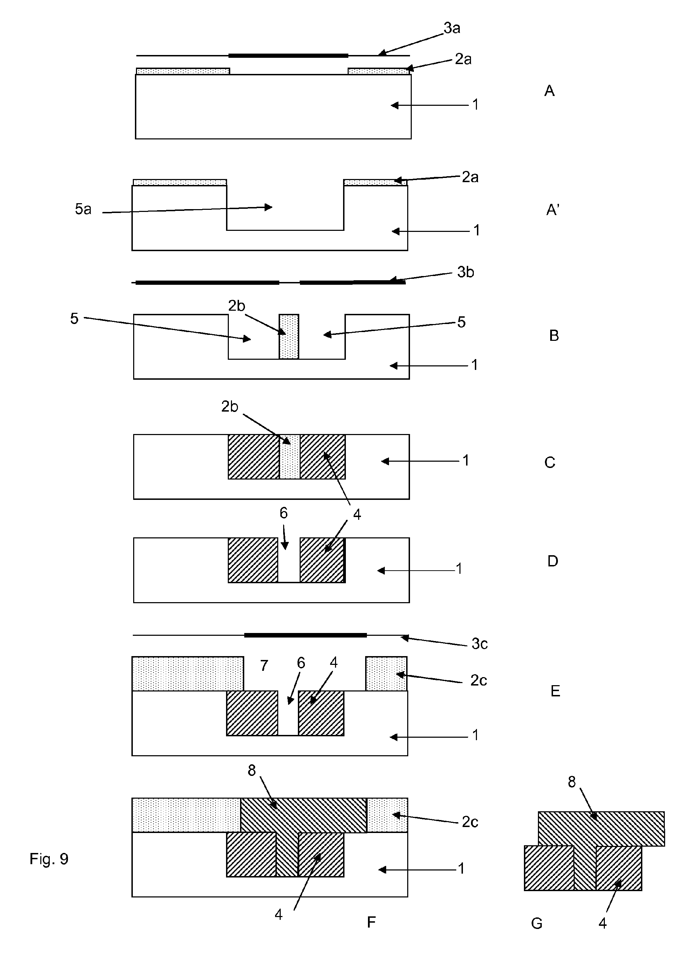

La figure 9 illustre un exemple d'une variante de la méthode dans lequel le premier moule est obtenu par une combinaison de gravure profonde du substrat et de procédé LIGA et le second moule est obtenu par le procédé LIGA uniquement.

A l'étape A, une couche de photoresist 2a est appliquée sur un substrat 1 et un premier photomasque 3a est utilisé pour définir la forme du contour du premier moule. L'opération de gravure profonde A' du substrat est effectuée en général par gravure sèche (gravure plasma, par exemple DRIE, Deep Reactive Ion Etching) ou humide (par exemple gravure KOH, hydroxyde de potassium) impliquant une attaque chimique sélective des parties du substrat non protégées par la résine structurée par illumination à travers le photomasque 3a. De cette gravure profonde résulte une cavité 5a constituant une première partie du moule du premier niveau.

A l'étape B, une seconde couche de photoresist 2b est déposée et irradiée au travers d'un second photomasque 3b de manière à créer une couche s'étendant partiellement sur le substrat au fond de la cavité 5a. L'épaisseur de cette couche peut être supérieure, inférieure ou égale à la profondeur de la cavité 5a et son contour est défini par le photomasque 3b. Les contours de la cavité 5a et de la couche de photoresist 2b et les parties de la cavité non occupées par le photoresist définissent le premier moule servant à former le premier niveau de la pièce finale. Une fois polymérisée, la couche de photoresist 2b dans la cavité 5a empêche, lors de l'étape C, l'électroformage de la première couche métallique 4 en permettant la croissance de la couche métallique seulement dans les parties du moule libres de photoresist formant la cavité 5.

A l'étape D, la seconde couche de photoresist 2b est enlevée pour laisser un espace 6 délimité par au moins un flanc de la couche métallique 4, le substrat 1 et le fond de la cavité 5 du premier moule. La surface de la première couche métallique 4 est ensuite usinée mécaniquement à une épaisseur prédéfinie.

A l'étape E, une troisième couche de photoresist 2c est appliquée sur le substrat 1 et irradiée au travers d'un troisième photomasque 3c de manière à s'étendre à la fois sur le substrat 1 et/ou sur au moins une partie de la première couche métallique 4, l'espace 6 étant protégé par le photomasque 3c. Cette troisième couche de photoresist 2c constitue le moule du second niveau.

Après polymérisation et élimination du photoresist non polymérisé, une seconde couche métallique 8 est déposée par électroformage dans le moule à l'étape F. Cette seconde couche métallique 8 croît depuis le substrat 1 au fond de la cavité, dans l'espace 6 le long des flancs de la première couche métallique 4, sur la première couche métallique 4 et sur la surface du substrat 1 dans le voisinage de la première couche métallique 4 afin d'occuper entièrement le moule du second niveau.

La surface de cette seconde couche métallique 8 est également usinée à une épaisseur prédéfinie avant l'enlèvement du substrat 1 et du photoresist polymérisé 2c du moule. La pièce métallique obtenue comporte ainsi deux niveaux auto assemblés dont les projections ne sont pas incluses l'une dans l'autre similaire à une pièce obtenue par les variantes de la méthode illustrées par les figures 5, 7, et 8.

En général, quelle que soit la méthode de réalisation du premier moule (en photoresist uniquement ou gravé dans le substrat ou encore une combinaison des deux méthodes) des niveaux additionnels peuvent être ajoutés préalablement au dépôt de la seconde couche métallique 8. Pour chaque niveau additionnel, les étapes suivantes sont effectuées:
- déposer au moins une couche additionnelle de photoresist (2d), irradier et polymériser au travers d'un masque additionnel la couche additionnelle de photoresist de sorte que la cavité (7) définie par la couche de photoresist immédiatement inférieure est incluse dans la cavité définie par la couche additionnelle (2d).

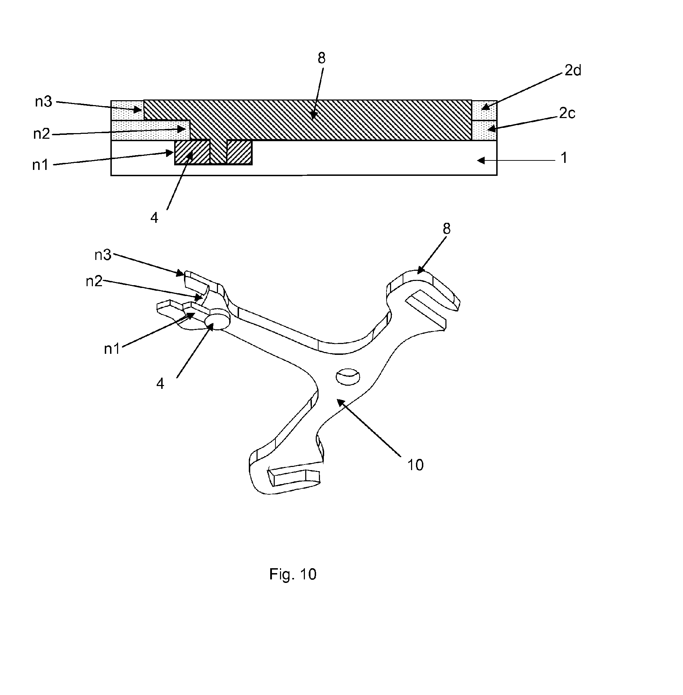

La pièce de la figure 10 comporte un niveau additionnel n3 au dessus des deux niveaux n1 et n2. Le contour du second niveau n2 comporte des parties incluses et des parties tangentes au contour du troisième niveau n3. Il s'agit ici d'une pièce 10 d'horlogerie, en l'occurrence une ancre à dard fabriquée en utilisant un premier moule gravé dans le substrat 1 pour réaliser le dard formé par la première couche métallique 4 du premier niveau n1. Les deux premiers niveaux n1 et n2 de la pièce sont réalisés selon les étapes de la figure 9 et le troisième niveau n3 est réalisé à l'aide d'un quatrième photomasque définissant un troisième moule dont la cavité se superpose à celle du second moule. Le second niveau n2 et le troisième niveau n3 formant l'ancre sont donc réalisé dans deux moules en photoresist dans les lesquels la seconde couche métallique 8 est déposée de manière à croître à la fois sur le substrat et le long du flanc d'un orifice de la première couche métallique 4 et dans la cavité formée par les deux moules superposés.

De nombreuses autres pièces d'horlogerie à niveaux multiples comme l'ancre à dard intégré de la figure 10, peuvent également être fabriquées selon la méthode, par exemple une roue, une came, un coeur, une aiguille, un plateau, etc. Leur caractéristique commune est qu'elles sont toutes auto assemblées avec au moins deux niveaux imbriqués l'un dans l'autre et dont les projections ne sont pas incluses l'une dans l'autre, c'est-à-dire que la projection orthogonale d'un niveau s'étend partiellement sur la projection orthogonale de l'autre niveau.

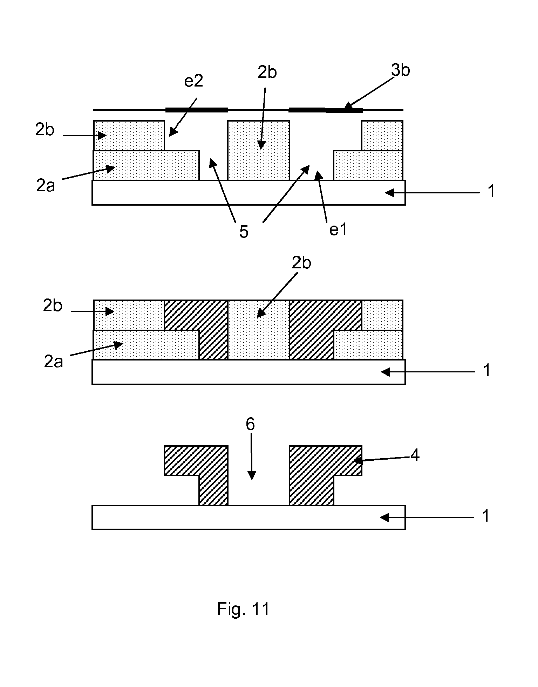

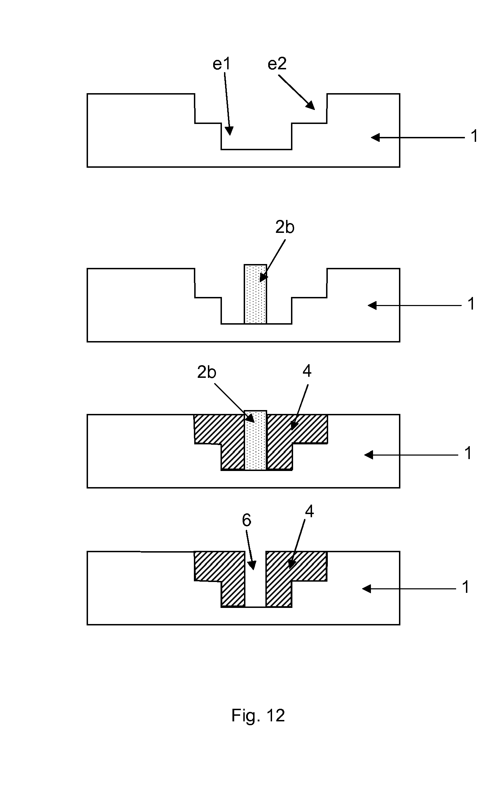

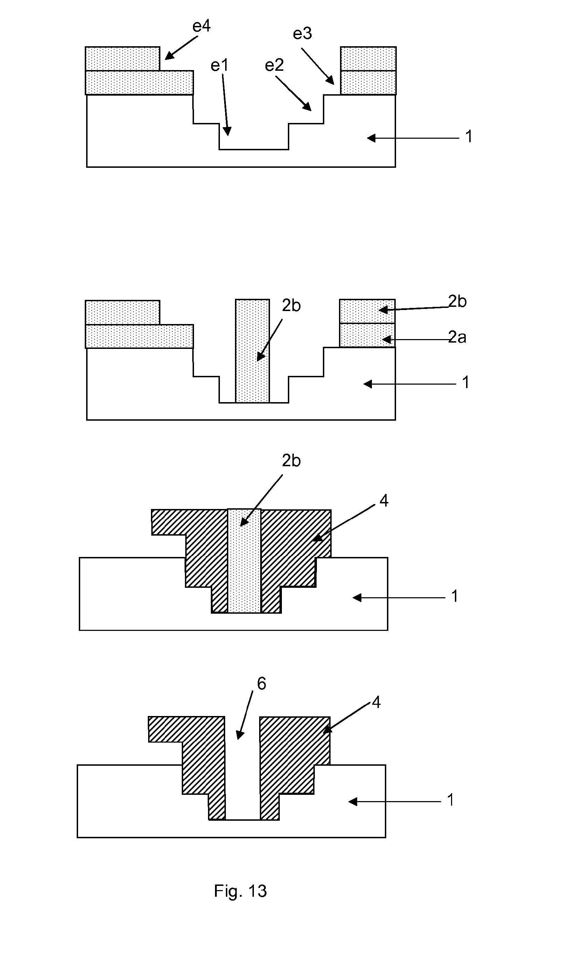

Pour des raisons de simplification, les figures 5 à 9 illustrent des variantes dans lesquelles le premier moule réalisé lors de l'étape A comporte un seul étage. Les figures 11 et 12 représentent des variantes dans lesquelles le premier moule comporte deux étages et la figure 13 un moule à quatre étages. Ce moule constituant le premier niveau de la pièce sert à l'électroformage de la première couche métallique 4. Le second niveau de la pièce constitué par la seconde couche métallique 8 imbriquée dans la première couche métallique 4 est réalisé de manière similaire aux variantes des figures 5 à 9, étapes D à F.

Le premier moule de la variante de la figure 11 comporte deux étages e1 et e2 formés dans deux couches de photoresist 2a et 2b réalisées chacune par dépôt de photoresist, irradiation à travers un photomasque et polymérisation. La couche métallique 4 croît depuis le substrat 1 au fond de la cavité 5 et le long des flancs des deux étages du moule. La couche 2b réalisée avec le photomasque 3b laisse un espace 6 destiné à l'imbrication de la seconde couche métallique du second niveau comme dans les variantes précédentes.

Le contour de la cavité du moule formée par un étage supérieur s'étend entièrement ou en parties au-delà du contour de la cavité d'un étage inférieur. Certaines portions du contour de deux étages peuvent coïncider et former un flanc continu d'épaisseur égale à celle de deux étages. Dans les autres portions du contour de la cavité où l'étendue de l'étage supérieur est plus grande, le flanc est discontinu en épaisseur et forme une marche d'escalier.

En d'autres termes, la projection du contour d'un étage inférieur de la cavité du moule est soit entièrement inscrite dans la projection du contour d'un étage supérieur, soit partiellement inscrite avec des portions de contour pouvant être tangentes au contour d'un étage supérieur.

La variante de la figure 12 est basée sur celle de la figure 9 avec un moule à deux étages e1 et e2 gravés dans le substrat 1. Une couche de photoresist 2b est déposée sur le substrat au fond de la cavité afin de créer un espace 6 dans la première couche métallique 4.

La variante mixte de la figure 13 illustre un exemple d'une combinaison des procédés de gravure profonde du substrat et du procédé LIGA pour réaliser un premier moule à quatre étages e1, e2, e3, e4. Les deux premiers étages e1 et e2 sont obtenus par gravure profonde, cf. figure 12 tandis que les deux étages supérieurs sont obtenus par le procédé LIGA, cf. figure 11.

Le moule illustré par la figure 13 comporte à la fois des portions de flanc continues et discontinues en épaisseur, notamment entre les étages e2 et e3 et entre les étages e3 et e4.

La méthode de l'invention et ses variantes s'appliquent également pour des pièces de plus de deux niveaux. Dans ce cas, les étapes D, E et F sont répétées autant de fois qu'il y a de niveaux à former au-dessus du premier niveau. Chaque niveau nécessite un photomasque particulier configuré de manière à libérer au moins un espace dans la couche métallique du niveau précédent et/ou sur son contour pour permettre l'imbrication des niveaux suivants les uns dans les autres.

## Revendications

1. Méthode de fabrication de pièces métalliques comportant au moins deux niveaux superposés auto-assemblés obtenus par photolithographie et électroformage, cette méthode comprenant les étapes suivantes:
- préparer un premier moule comportant une cavité avec au moins un étage, ledit premier moule définissant un premier niveau est préparé selon les étapes suivantes :
- déposer et irradier au travers d'un premier photomasque (3a), une première couche de photorésist (2a) appliquée sur un substrat (1),
- polymériser la première couche de photorésist (2a)
- éliminer la couche de photorésist non polymérisée, la partie de photoresist restante constituant le premier moule formé par le photoresist et comportant au moins une cavité (5).
- déposer une première couche métallique (4) par électroformage dans la cavité (5) du premier moule,
- enlever le photoresist (2a) polymérisé du premier moule,
- déposer une seconde couche de photorésist (2b) appliquée sur le substrat (1), irradier et polymériser au moyen d'un second photomasque (3b), en masquant tout ou partie de la première couche métallique (4) à l'exception d'au moins un flanc de la première couche métallique (4), ladite seconde couche de photoresist (2b), étant d'épaisseur égale ou supérieure à l'épaisseur de la première couche métallique (4),
- éliminer la couche de photorésist non polymérisée, de manière à laisser au moins un espace (6) traversant libre de photoresist adjacent au flanc de la première couche métallique (4),
la méthode est caractérisée en qu'elle comprend les étapes consistant à :
- déposer une troisième couche de photorésist (2c) et l'irradier au travers d'un troisième photomasque (3c), ayant un motif configuré de manière à masquer une zone s'étendant partiellement ou entièrement sur la première couche métallique (4), une zone extérieure au voisinage de ladite première couche métallique (4) et l'espace (6) adjacent au flanc de la première couche métallique (4),
- polymériser la troisième couche de photoresist (2c) et éliminer la couche de photorésist non polymérisée, la partie de photoresist restante constituant une cavité (7) d'un second moule, l'espace (6) adjacent au flanc de la première couche métallique (4) étant libre de photoresist.
- déposer une seconde couche métallique (8) par électroformage dans la cavité (7) et l'espace (6) en créant une liaison intime entre la seconde couche métallique (8) et au moins un flanc de la première couche métallique (4) et résultant en un auto-assemblage entre les deux niveaux de la pièce,
- usiner par un procédé mécanique la seconde couche métallique (8) à une épaisseur prédéfinie,
- enlever le photoresist polymérisé du moule du second niveau ainsi que le substrat (1),
- obtention d'une pièce métallique comportant deux niveaux superposés imbriqués l'un dans l'autre, la projection orthogonale d'un niveau s'étendant partiellement sur la projection orthogonale de l'autre niveau, le contour et le positionnement relatif de chaque niveau étant défini par photolithographie.

2. Méthode de fabrication de pièces métalliques comportant au moins deux niveaux superposés auto-assemblés obtenus par photolithographie et électroformage, cette méthode comprenant les étapes suivantes:
- préparer un premier moule comportant une cavité (5) avec au moins un étage, ledit premier moule définissant un premier niveau est préparé selon les étapes suivantes :
- déposer et irradier au travers d'un premier photomasque (3a), une première couche de photorésist (2a) appliquée sur un substrat (1),
- polymériser la première couche de photorésist (2a) et éliminer la couche de photorésist non polymérisée,
- graver la partie du substrat non masquée par le photoresist, la partie gravée du substrat constituant une cavité (5a) d'une première partie du premier moule,
- déposer et irradier au travers d'un second photomasque (3b) une seconde couche de photoresist (2b) appliquée sur le substrat et dans la cavité (5a) de la partie gravée,
- polymériser la seconde couche de photorésist (2b) et éliminer la couche de photorésist non polymérisée, la partie de photoresist restante (2b) empêchant l'électroformage subséquent de remplir totalement la cavité (5a) gravée dans le substrat et constituant avec ladite cavité (5a) un premier moule,
- déposer une première couche métallique (4) par électroformage dans la cavité (5) du premier moule
- enlever le photoresist (2b) polymérisé du premier moule afin de libérer un espace (6) dans la première couche métallique (4),
la méthode est **caractérisée en ce qu'**elle comprend les étapes consistant à:
- déposer une troisième couche de photorésist (2c) sur le substrat (1) et l'irradier au travers d'un troisième photomasque (3c), en masquant au moins une zone définie par le flanc de la première couche métallique (4),
et l'espace (6) dans la première couche métallique
- polymériser la troisième couche de photoresist (2c) et éliminer la couche de photorésist non polymérisée, la partie de photoresist restante constituant une cavité (7) d'un second moule, l'espace (6) dans la première couche métallique (4) étant libre de photoresist.
- déposer une seconde couche métallique (8) par électroformage dans la cavité (7) et l'espace (6) en créant une liaison intime entre la seconde couche métallique (8) et au moins un flanc de la première couche métallique (4) et résultant en un auto-assemblage entre les deux niveaux,
- usiner par un procédé mécanique la seconde couche métallique (8) à une épaisseur prédéfinie,
- enlever le photoresist polymérisé du moule du second niveau ainsi que le substrat (1),
- obtention d'une pièce métallique comportant deux niveaux superposés imbriqués l'un dans l'autre, la projection orthogonale d'un niveau s'étendant partiellement sur la projection orthogonale de l'autre niveau, le contour et le positionnement relatif de chaque niveau étant défini par photolithographie.

3. Méthode selon la revendication 1 ou 2 **caractérisée en ce qu'**elle comprend les étapes suivantes, préalablement au dépôt de la seconde couche métallique (8) :
- déposer au moins une couche additionnelle de photoresist (2d), irradier et polymériser au travers d'un masque additionnel la couche additionnelle de photoresist de sorte que la cavité (7) définie par la couche de photoresist immédiatement inférieure est incluse dans la cavité définie par la couche additionnelle (2d).

4. Méthode selon l'une des revendications 1 à 3 **caractérisée en ce que** l'espace (6) dans la première couche métallique (4) est entièrement entouré par le métal de ladite première couche métallique (4) en formant un orifice dont la forme est définie par le premier photomasque (3a), ledit orifice (6) traverse entièrement la première couche métallique (4) jusqu'au substrat (1), la seconde couche métallique (8) remplissant entièrement l'orifice (6) à partir du substrat (1) en se liant intimement avec la première couche métallique (4) par les flancs de l'orifice (6).

5. Méthode selon l'une des revendications 1 ou 3 **caractérisée en ce que** l'espace (6) dans la première couche métallique (4) définit un contour comprenant au moins une partie concave et une partie convexe formé par une portion de flanc de la première couche métallique (4) et par une portion de flanc de la seconde couche de photoresist (2b), la seconde couche métallique (8) enrobant le contour de la première couche métallique (4) en remplissant l'espace (6) à partir du substrat (1).

6. Méthode selon la revendication 2 **caractérisée en ce que** l'espace (6) dans la première couche métallique (4) définit un contour comprenant au moins une partie concave et une partie convexe formé par une portion de flanc de la première couche métallique (4) et par une portion de flanc de la cavité (5a) dans le substrat, la seconde couche métallique (8) enrobant le contour de la première couche métallique (4) en remplissant l'espace (6) à partir du substrat (1).

7. Méthode selon l'une des revendications 5 ou 6 **caractérisée en ce que** le flanc de la première couche métallique le long duquel la liaison entre les niveaux est effectuée est optimisé de manière à maximiser la surface de liaison entre les couches métalliques.

8. Méthode selon l'une des revendications 1 à 7 **caractérisée en ce que** l'électroformage de la première couche métallique est réalisé en un premier métal et l'électroformage de la deuxième couche métallique est réalisé en un deuxième métal différent du premier métal.

9. Méthode selon l'une des revendications 1 à 8 **caractérisée en ce qu'**elle comprend après l'étape de dépose de la première couche métallique (4) une étape d'usinage par un procédé mécanique de cette couche métallique (4) à une épaisseur prédéfinie.

10. Pièce micro mécanique composée d'au moins deux niveaux constitués chacun par une couche métallique obtenue par photolithographie, grâce à un moule de photoresist ou gravé dans un substrat, et par électroformage, **caractérisée en ce que** la couche métallique du second niveau (8) est imbriquée et intimement liée à la couche métallique du premier niveau (4) par au moins une portion de surface et de flanc de la couche métallique dudit premier niveau et **en ce que** le second niveau s'étend partiellement sur le premier niveau et sur une zone extérieure au voisinage dudit premier niveau de sorte que le contour d'une projection orthogonale du second niveau englobe une partie du contour du premier niveau.

11. Pièce selon la revendication 10, **caractérisée en ce qu'**elle comprend un niveau intermédiaire s'étendant partiellement sur le premier niveau et situé entre le premier et le second niveau, ledit second niveau s'étendant partiellement sur le niveau intermédiaire et sur une zone extérieure au voisinage dudit niveau intermédiaire de sorte que le contour d'une projection orthogonale du second niveau englobe une partie du contour du premier niveau.

12. Pièce selon la revendication 10 ou 11 **caractérisée en ce que** la couche métallique du premier niveau est constituée par un premier métal et la couche métallique du second niveau est constituée par un deuxième métal différent du premier métal.

13. Pièce selon l'une des revendications 10 à 12, **caractérisée en ce que** la couche métallique du second niveau est imbriquée et intimement liée à la couche métallique du premier niveau à travers au moins un orifice formé dans la couche métallique du premier niveau.

14. Pièce selon l'une des revendications 10 à 13, **caractérisée en ce que** la couche métallique du second niveau est imbriquée et intimement liée à la couche métallique du premier niveau par au moins une portion de flanc formant un contour comprenant une suite de parties convexes et concaves de sorte que la couche métallique du second niveau enserre une portion de la couche métallique du premier niveau.

## Patentansprüche

1. Verfahren zur Herstellung von Metallstücken mit mindestens zwei sich selbst aufbauenden überlagerten Lagen, erhalten durch Fotolithografie und Elektroformverfahren, wobei dieses Verfahren die folgenden Schritte umfasst:
- Herstellung einer ersten Form mit einem Hohlraum mit mindestens einer Stufe, wobei die erste Form, die ein erstes Niveau definiert, in folgenden Schritten hergestellt wird:
- Auftragung und Bestrahlung, durch ein erste Fotomaske (3a), einer ersten Fotoresistschicht (2a), die auf einem Substrat (1) angebracht ist,
- Polymerisieren der ersten Fotoresistschicht (2a),
- die nicht polymerisierte Fotoresistschicht beseitigen, so dass das übrige Fotoresistteil die erste Form darstellt, die von dem Fotoresist gebildet wird und mindestens einen Hohlraum (5) umfasst.
- Auftragung einer ersten Metallschicht (4) durch Elektroformverfahren in dem Hohlraum (5) der ersten Form,
- Entfernung des polymerisierten Fotoresists (2a) aus der ersten Form,
- Auftragung einer zweiten Fotoresistschicht (2b), die auf dem Substrat (1) angebracht, bestrahlt und mittels einer zweiten Fotomaske (3b) polymerisiert wird, indem man die ganze oder ein Teil der ersten Metallschicht (4), außer mindestens einer Flanke der ersten Metallschicht (4), maskiert, wobei die zweite Fotoresistschicht (2b) ebenso dick oder dicker als die erste Metallschicht (4) ist,
- Entfernung der nicht polymerisierten Fotoresistschicht, wobei man mindestens einen Raum (6) an der Flanke der ersten Metallschicht (4) fotoresistfrei lässt,
die Methode ist **dadurch gekennzeichnet, dass** sie folgende Phasen umfasst:
- Auftragung einer dritten Fotoresistschicht (2c) und ihre Bestrahlung durch ein dritte Fotomaske (3c), mit einem so gestalteten Motiv, dass sie einen Bereich maskiert, der sich teilweise oder ganz auf die erste Metallschicht (4), einen äußeren Bereich in der Nähe der ersten Metallschicht (4) und den Raum (6) angrenzend an die Flanke der ersten Metallschicht (4) erstreckt,
- Polymerisierung der dritten Fotoresistschicht (2c) und Entfernung der nicht polymerisierten Fotoresistschicht, so dass das übrige Fotoresistteil einen Hohlraum (7) einer zweiten Form darstellt, wobei der Raum (6) angrenzend an die Flanke der ersten Metallschicht (4) fotoresistfrei ist.
- Auftragung einer zweiten Metallschicht (8) durch Elektroformverfahren in dem Hohlraum (7) und in dem Raum (6), indem man eine enge Verbindung zwischen der zweiten Metallschicht (8) und mindestens einer Flanke der ersten Metallschicht (4) schafft, die zu einem Selbstzusammenbau zwischen den beiden Niveaus des Stückes führt,
- Bearbeitung, durch ein mechanisches Verfahren, der zweiten Metallschicht (8) auf eine vorherbestimmte Dicke,
- Entfernung des polymerisierten Fotoresists aus der Form des zweiten Niveaus sowie Entfernung des Substrats (1),
- Erhalt eines Metallstücks mit zwei ineinander verschachtelten überlagerten Niveaus, wobei die Orthogonalprojektion eines Niveaus sich teilweise auf die Orthogonalprojektion des anderen Niveaus erstreckt und der Umriss und die relative Positionierung jedes Niveaus durch Fotolithografie definiert sind.

2. Verfahren zur Herstellung von Metallstücken mit mindestens zwei sich selbst aufbauenden überlagerten Niveaus, erhalten durch Fotolithografie und Elektroformverfahren, wobei dieses Verfahren die folgenden Schritte umfasst:
- Herstellung einer ersten Form mit einem Hohlraum (5) mit mindestens einer Stufe, wobei die erste Form, die ein erstes Niveau definiert, in folgenden Schritten hergestellt wird:
- Auftragung und Bestrahlung, durch eine erste Fotomaske (3a), einer ersten Fotoresistschicht (2a), die auf einem Substrat angebracht (1) ist,
- Polymerisierung der ersten Fotoresistschicht (2a) und Entfernung der nicht polymerisierten Fotoresistschicht,
- Gravierung des nicht durch das Fotoresist maskierten Teils des Substrats, wobei das gravierte Teil des Substrats einen Hohlraum (5a) eines ersten Teils der ersten Form darstellt,
- Auftragung und Bestrahlung, durch eine zweite Fotomaske (3b), einer zweiten Fotoresistschicht (2b), die auf dem Substrat und in dem Hohlraum (5a) des gravierten Teils angebracht ist,
- Polymerisierung der zweiten Fotoresistschicht (2b) und Entfernung der nicht polymerisierten Fotoresistschicht, wobei das übrige Fotoresistteil (2b) verhindert, dass das nachfolgende Elektroformverfahren völlig den Hohlraum (5a) füllt, der in das Substrat graviert ist, und mit besagtem Hohlraum (5a) eine erste Form bildet,
- Auftragung einer ersten Metallschicht (4) durch Elektroformverfahren in dem Hohlraum (5) der ersten Form
- Entfernung des polymerisierten Fotoresists (2b) der ersten Form, um einen Raum (6) in der ersten Metallschicht (4) freizulegen,
die Methode ist **dadurch gekennzeichnet, dass** sie folgende Phasen umfasst:
- Auftragung einer dritten Fotoresistschicht (2c) auf das Substrat und ihre Bestrahlung durch ein dritte Fotomaske (3c), indem man mindestens einen Bereich maskiert, der von der Flanke der ersten Metallschicht (4) und dem Raum (6) in der ersten Metallschicht definiert ist
- Polymerisierung der dritten Fotoresistschicht (2c) und Entfernung der nicht polymerisierten Fotoresistschicht, wobei das übrige Fotoresistteil einen Hohlraum (7) einer zweiter Form darstellt und der Raum (6) in der ersten Metallschicht (4) fotoresistfrei ist.
- Auftragung einer zweiten Metallschicht (8) durch Elektroformverfahren in den Hohlraum (7) und den Raum (6), indem man eine enge Verbindung zwischen der zweiten Metallschicht (8) und mindestens einer Flanke der ersten Metallschicht (4) schafft, und die zu einem Selbstzusammenbau zwischen den beiden Niveaus führt,
- Bearbeitung, durch ein mechanisches Verfahren, der zweiten Metallschicht (8) auf eine vorherbestimmte Dicke,
- Entfernung des polymerisierten Fotoresists aus der Form des zweiten Niveaus sowie Entfernung des Substrats (1),
- Erhalt eines Metallstücks mit zwei ineinander verschachtelten überlagerten Niveaus, wobei die Orthogonalprojektion eines Niveaus sich teilweise auf die Orthogonalprojektion des anderen Niveaus erstreckt, wobei der Umriss und die relative Positionierung jedes Niveaus durch Fotolithografie definiert ist.

3. Verfahren nach Anspruch 1 oder 2, **dadurch gekennzeichnet, dass** es die folgenden Schritte umfasst, vor der Auftragung der zweiten Metallschicht (8):
- Auftragung mindestens einer zusätzlichen Fotoresistschicht (2d), Bestrahlung und Polymerisierung, durch eine zusätzliche Maske, der zusätzlichen Fotoresistschicht, so dass der Hohlraum (7), der durch die direkt darunterliegende Fotoresistschicht definiert ist, in den Hohlraum eingeschlossen ist, der durch die zusätzliche Schicht (2d) definiert ist.

4. Verfahren nach einem der Ansprüche 1 bis 3, **gekennzeichnet dadurch dass** der Raum (6) in der ersten Metallschicht (4) ganz von dem Metall der ersten Metallschicht (4) umgeben ist, wobei eine Öffnung entsteht, deren Form durch die erste Fotomaske (3a) definiert ist, und wobei die Öffnung (6) die erste Metallschicht (4) vollständig bis zum Substrat (1) durchquert, wobei die zweite Metallschicht (8) vollständig die Öffnung (6) ausgehend von dem Substrat einnimmt (1), durch enge Verbindung mit der ersten Metallschicht (4) an den Flanken der Öffnung (6).

5. Verfahren nach einem der Ansprüche 1 oder 3, **gekennzeichnet dadurch, dass** der Raum (6) in der ersten Metallschicht (4) einen Umriss definiert, der mindestens ein konkaves Teil und ein konvexes Teil umfasst, gebildet von einem Flankenteil der ersten Metallschicht (4) und von einem Flankenteil der zweiten Fotoresistschicht (2b), wobei die zweite Metallschicht (8) den Umriss der ersten Metallschicht (4) einbettet, indem sie den Raum (6) ausgehend von dem Substrat (1) ausfüllt.

6. Verfahren nach Anspruch 2, **gekennzeichnet dadurch, dass** der Raum (6) in der ersten Metallschicht (4) einen Umriss mit mindestens einem konkaven Teil und einem konvexen Teil definiert, gebildet durch einen Flankenteil der ersten Metallschicht (4) und durch einen Flankenteil des Hohlraums (5a) in dem Substrat, wobei die zweite Metallschicht (8) den Umriss der ersten Metallschicht (4) einbettet, indem sie den Raum (6) ausgehend von dem Substrat (1) ausfüllt.

7. Verfahren nach einem der Ansprüche 5 oder 6, **gekennzeichnet dadurch, dass** die Flanke der ersten Metallschicht, an der entlang die Verbindung zwischen den Niveaus durchgeführt wird, optimiert ist, um die Verbindungsoberfläche zwischen den Metallschichten zu maximieren.

8. Verfahren nach einem der Ansprüche 1 bis 7 **gekennzeichnet dadurch, dass** das Elektroformverfahren der ersten Metallschicht in einem erstem Metall verwirklicht wird und das Elektroformverfahren der zweiten Metallschicht in einem zweiten Metall, das ein anderes als das erste Metall ist.

9. Verfahren nach einem der Ansprüche 1 bis 8, **dadurch gekennzeichnet, dass** es nach der Auftragung der ersten Metallschicht (4) eine Phase der Bearbeitung dieser Metallschicht (4) durch ein mechanisches Verfahren auf eine vorherbestimmte Dicke umfasst.

10. Mikromechanisches Stück, zusammengesetzt aus mindestens zwei Niveaus, von denen jedes aus einer Metallschicht besteht, die durch Fotolithografie erhalten wird, dank einer Fotoresistform oder in ein Substrat eingraviert, und durch Elektroformverfahren, **gekennzeichnet dadurch, dass** die Metallschicht des zweiten Niveaus (8) mit der Metallschicht des erste Niveaus (4) durch mindestens ein Oberflächen- und Flankenteil der Metallschicht des ersten Niveaus verschachtelt und eng verbunden ist sowie dadurch, dass das zweite Niveau sich teilweise auf das erste Niveau erstreckt und auf einen äußeren Bereich in der Nähe des ersten Niveaus, so dass der Umriss einer Orthogonalprojektion des zweiten Niveaus einen Teil des Umrisses des ersten Niveaus umfasst.

11. Stück nach Anspruch 10, **dadurch gekennzeichnet, dass** es eine Zwischenebene umfasst, die sich teilweise auf das erste Niveau erstreckt und zwischen dem ersten und dem zweite Niveau liegt, wobei das zweite Niveau sich teilweise auf die Zwischenebene erstreckt und auf einen äußeren Bereich in der Nähe der Zwischenebene, so dass der Umriss einer Orthogonalprojektion des zweiten Niveaus einen Teil des Umrisses des ersten Niveaus umfasst.

12. Stück nach Anspruch 10 oder 11, **gekennzeichnet dadurch, dass** die Metallschicht des ersten Niveaus aus einem erste Metall besteht und die Metallschicht des zweiten Niveaus aus einem zweiten Metall, das ein anderes als das erste Metall ist.

13. Stück nach einem der Ansprüche 10 bis 12, **gekennzeichnet dadurch, dass** die Metallschicht des zweiten Niveaus mit der Metallschicht des ersten Niveaus durch mindestens eine Öffnung in der Metallschicht des ersten Niveaus verschachtelt und eng verbunden ist.

14. Stück nach einem der Ansprüche 10 bis 13, **gekennzeichnet dadurch, dass** die Metallschicht des zweiten Niveaus mit der Metallschicht des ersten Niveaus durch mindestens ein Flankenteil verschachtelt und eng verbunden ist, das einen Umriss mit einer Folge von konvexen und konkaven Teilen bildet, so dass die Metallschicht des zweiten Niveaus einen Teil der Metallschicht des ersten Niveaus umschließt.

## Claims

1. Method for manufacturing metallic pieces including at least two self-assembled superimposed levels obtained by photolithography and electroforming, this method comprising the following steps:
- preparing a first mould including a cavity with at least one stage, said first mould defining a first level is prepared according to the following steps:
- depositing and irradiating through a first photomask (3a), a first photoresist layer (2a) applied on a substrate (1),
- polymerizing the first photoresist layer (2a),
- eliminating the non-polymerized photoresist layer, the remaining photoresist part constituting the first mould formed by the photoresist and including at least one cavity (5).
- depositing a first metallic layer (4) by electroforming in the cavity (5) of the first mould,
- removing the polymerized photoresist (2a) from the first mould,
- depositing a second photoresist layer (2b) applied on the substrate (1), irradiating and polymerizing by means of a second photomask (3b), by masking all or part of the first metallic layer (4) except at least one side wall of the first metallic layer (4), said second photoresist layer (2b), having a thickness equal or greater than the thickness of the first metallic layer (4),
- eliminating the non-polymerized photoresist layer, in order to leave at least one traversing space (6) free of photoresist adjacent to the side wall of the first metallic layer (4),
the method is **characterized in that** it comprises steps of:
- applying a third photoresist layer (2c) and irradiating it through a third photomask (3c), having a pattern configured in order to mask an area extending partially or entirely on the first metallic layer (4), an external area close to said first metallic layer (4) and the space (6) adjacent to the side wall of the first metallic layer (4),
- polymerizing the third photoresist layer (2c) and eliminating the non-polymerized photoresist layer, the remaining photoresist part forming a cavity (7) of a second mould, the space (6) adjacent to the side wall of the first metallic layer (4) being free of photoresist.
- depositing a second metallic layer (8) by electroforming in the cavity (7) and the space (6) by creating an intimate connection between the second metallic layer (8) and at least one side wall of the first metallic layer (4) and resulting in a self-assembling between the two levels of the piece,
- machining, by a mechanical process, the second metallic layer (8) to a predefined thickness,
- removing the polymerized photoresist of the mould of the second level as well as the substrate (1),
- obtaining a metallic piece including two superimposed levels interlocking each other, the orthogonal projection of one level extending partially on the orthogonal projection of the other level, the contour and the relative positioning of each level being defined by photolithography.

2. Method for manufacturing metallic pieces including at least two self-assembled superimposed levels obtained by photolithography and electroforming, this method comprising the following steps:
- preparing a first mould including a cavity (5) with at least one stage, said first mould defining a first level is prepared according to the following steps:
- depositing and irradiating, through a first photomask (3a), a first photoresist layer (2a) applied on a substrate (1),
- polymerizing the first photoresist layer (2a) and eliminating the non-polymerized photoresist layer,
- engraving the part of the substrate not masked by the photoresist, the engraved part of the substrate forming a cavity (5a) of a first part of the first mould,
- depositing and irradiating through a second photomask (3b) a second photoresist layer (2b) applied on the substrate and in the cavity (5a) of the engraved part,
- polymerizing the second photoresist layer (2b) and eliminating the non-polymerized photoresist layer, the remaining photoresist part (2b) preventing the subsequent electroforming from totally filling the cavity (5a) engraved in the substrate and forming with said cavity (5a) a first mould,
- depositing a first metallic layer (4) by electroforming in the cavity (5) of the first mould,
- removing the polymerized photoresist (2b) of the first mould in order to free a space (6) in the first metallic layer (4),
the method being **characterized in that** it comprises steps of:
- depositing a third photoresist layer (2c) on the substrate and irradiating it through a third photomask (3c), by masking at least one area defined by the side wall of the first metallic layer (4), and the space (6) in the first metallic layer,
- polymerizing the third photoresist layer (2c) and eliminating the non-polymerized photoresist layer, the remaining photoresist part forming a cavity (7) of a second mould, the space (6) in the first metallic layer (4) being free of photoresist.
- depositing a second metallic layer (8) by electroforming in the cavity (7) and the space (6) by creating an intimate connection between the second metallic layer (8) and at least one side wall of the first metallic layer (4) and resulting in a self-assembling between the two levels,
- machining, by a mechanical process, the second metallic layer (8) to a predefined thickness,
- removing the polymerized photoresist from the mould of the second level as well as the substrate (1),
- obtaining a metallic piece including two superimposed levels interlocking each other, the orthogonal projection of one level extending partially on the orthogonal projection of the other level, the contour and the relative positioning of each level being defined by photolithography.

3. Method according to claim 1 or 2 **characterized in that** it comprises the following steps, before depositing the second metallic layer (8):
- depositing at least one additional photoresist layer (2d), irradiating and polymerizing the additional photoresist layer through an additional mask so that the cavity (7) defined by the photoresist layer immediately below is included in the cavity defined by the additional layer (2d).

4. Method according to anyone of claims 1 to 3 **characterized in that** the space (6) in the first metallic layer (4) is entirely surrounded by the metal of said first metallic layer (4) forming an opening which shape is defined by the first photomask (3a), said opening (6) traversing entirely the first metallic layer (4) until the substrate (1), the second metallic layer (8) entirely filling the opening (6) starting from the substrate (1) by connecting intimately with the first metallic layer (4) by the side walls of the opening (6).

5. Method according to anyone of claims 1 or 3 **characterized in that** the space (6) in the first metallic layer (4) defines a contour comprising at least one concave part and one convex part formed by a side wall portion of the first metallic layer (4) and by a side wall portion of the second photoresist layer (2b), the second metallic layer (8) coating the contour of the first metallic layer (4) by filling the space (6) starting from the substrate (1).

6. Method according to claim 2 **characterized in that** the space (6) in the first metallic layer (4) defines a contour comprising at least one concave part and one convex part formed by a side wall portion of the first metallic layer (4) and by a side wall portion of the cavity (5a) in the substrate, the second metallic layer (8) coating the contour of the first metallic layer (4) filling the space (6) starting from the substrate (1).

7. Method according to claim 5 or 6 **characterized in that** the side wall of the first metallic layer along which the connection between the levels is carried out is optimized in order to maximize the connection surface between the metallic layers.

8. Method according to anyone of claims 1 to 7 **characterized in that** the electroforming of the first metallic layer is achieved in a first metal and the electroforming of the second metallic layer is achieved in a second metal, different from the first metal.

9. Method according to anyone of claims 1 to 8 **characterized in that**, it comprises after the step of depositing the first metallic layer (4), a step of machining, by a mechanical process, this metallic layer (4) to a predefined thickness.

10. Micromechanical piece composed of at least two levels each formed by a metallic layer obtained by photolithography, thanks to a photoresist mould or engraved in a substrate, and by electroforming, **characterized in that** the metallic layer of the second level (8) is interlocked with and intimately connected to the metallic layer of the first level (4) by at least one portion of surface and side wall of the metallic layer of said first level and **in that** the second level partially extends on the first level and on an external area close to said first level so that the contour of an orthogonal projection of the second level includes a part of the contour of the first level.

11. Piece according to claim 10, **characterized in that** it comprises an intermediate level extending partially on the first level and situated between the first and the second level, said second level extending partially on the intermediate level and on an external area close to said intermediate level so that the contour of an orthogonal projection of the second level includes a part of the contour of the first level.

12. Piece according to claim 10 or 11 **characterized in that** the metallic layer of the first level is formed by a first metal and the metallic layer of the second level is formed by a second metal different from the first metal.

13. Piece according to anyone of claims 10 to 12, **characterized in that** the metallic layer of the second level is interlocked with and intimately connected to the metallic layer of the first level through at least one opening formed in the metallic layer of the first level.

14. Piece according to anyone of claims 10 to 13, **characterized in that** the metallic layer of the second level is interlocked with and intimately connected to the metallic layer of the first level by at least one side wall portion forming a contour comprising a sequence of concave and convex parts so that the metallic layer of the second level encloses a portion of the metallic layer of the first level.
